# EUROPEAN PATENT APPLICATION

(11) **EP 1 758 437 A2**
(43) Date of publication of application: **28.02.2007**
(21) Application number: 06017441.4
(22) Date of filing: 22.08.2006
(51) Int. Cl.: H05K 3/46, H05K 1/03, H05K 3/00

(54) **Laminated structure including a resin layer containing a glass-cloth and method for manufacturing the same**

(30) Priority: 25.08.2005 JP 2005244219
(71) Applicant: SHINKO ELECTRIC INDUSTRIES CO., LTD., Nagano-shi, Nagano 381-2287 (JP)
(72) Inventor: Machida, Yoshihiro, Nagano-shi Nagano, 381-2287 (JP); Harayama, Kosaku, Nagano-shi Nagano, 381-2287 (JP); Yamano, Takaharu, Nagano-shi Nagano, 381-2287 (JP)
(74) Representative: Zimmermann, Gerd Heinrich

(57) **Abstract**

The laminated product in a structure including a glass-cloth containing resin layer according to this invention is a laminated product in which a wiring layer and an insulating layer laminated one on the other are included and different wiring layers are electrically connected to each other by a via hole passing through the insulating layer, characterized in that at least one insulating layer 11 is formed of a laminated body including an insulating resin layer 7 on a lower wiring layer 5 and a glass-cloth containing resin layer 9 thereon, and in the laminated body, a via hole 17 continuously passes through from the upper glass-cloth containing resin layer 9 to the lower insulating resin layer 7.

## Description

This invention relates to a laminated product, in particular to a laminated product in a structure including a glass-cloth containing resin layer, and to a method for manufacturing the same. More specifically, this invention relates to a product in a multiple-layer structure including a layer of glass-cloth containing resin known as "prepreg" as a reinforcement layer, e.g. a product such as a multiple-layer substrate or package, and a method for manufacturing the same.

As a method for manufacturing a multiple-layer structure such as a multiple-layer wiring board, a "build-up" technique is known. In the build-up technique, on a core substrate with a wiring layer formed as a first layer, insulating layers and wiring layers are alternately formed, or formed one on the other, to form a wiring board in a multiple-layer structure. For conduction between different wiring layers, a via hole passing through the insulating layers between these wiring layers is made.

In order to satisfy the demand of downsizing or weight-reduction in recent years for electronic components, low-profiling of the multiple-layer wiring board is required. In order to realize this, in recent years, the product in a multiple-layer structure has been manufactured by inserting a prepreg layer giving a high reinforcement effect. This is attributable to the fact that although the prepreg is known as a material inferior in laser processing, owing to improvements of a laser processing technique, also in the multiple-layer structure including a prepreg layer for reinforcement, the via hole for conduction between the layers has become capable of being formed.

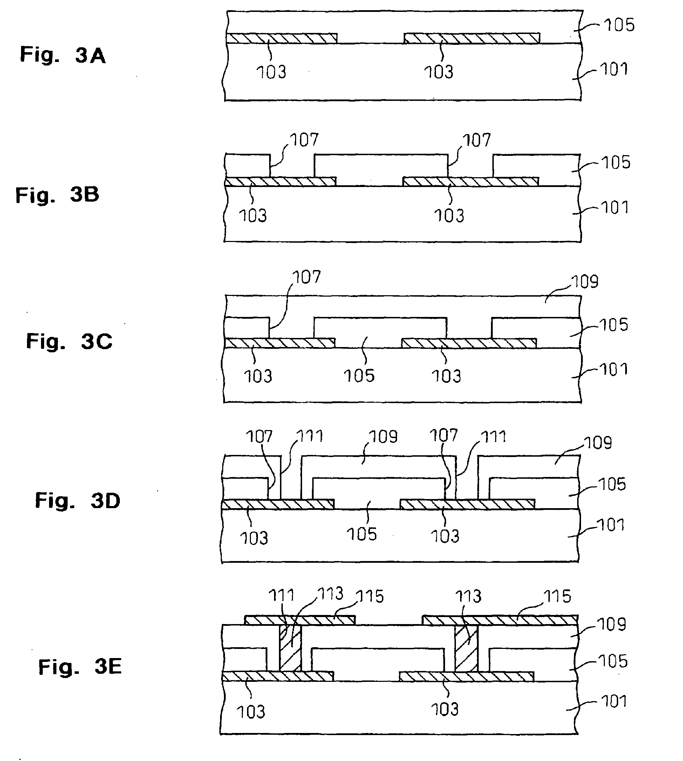

A technique for making the via hole in fabrication of the wiring board in the multiple-layer structure including the prepreg is disclosed in JP-A-2004-356232 (henceforth referred to as Patent Reference 1). In accordance with this technique, as shown in Fig. 3A, after a prepreg insulating layer 105 overlying a lower wiring layer 103 formed on a substrate 101 has been formed, as shown in Fig. 3B, a large-diameter hole 107 from which a part of the lower wiring layer 103 is exposed is made thereon by laser processing. Next, as shown in Fig. 3C, an insulating resin layer 109 overlying the prepreg insulating layer 105 is formed. Further, as shown in Fig. 3D, inside the large-diameter hole 107, a small-diameter hole 111 is made by laser processing. Thereafter, as shown in Fig. 3E, the small-diameter hole 111 is subjected to conducting processing to form a via hole 113. After the via hole 113 has been formed, an upper wiring layer 115 connected to the via hole 113 can be formed.

In the method for manufacturing the multiple-layer wiring board disclosed in Patent Reference 1, the laser processing must be done twice in the formation of the via hole 113 for making the larger-diameter hole 107 and small-diameter hole 111, thereby complicating the processing steps. In addition, in order to make the small-diameter hole inside the large-diameter hole, higher laser processing accuracy is required than the case of making a single hole. Further, subjecting the small-diameter hole 111 which is preferably 120 to 50 µm to the conducting processing cannot be carried out so easily.

The present invention intends to reduce at least some of the above problems. The object is solved by the laminated product according to independent claim 1, and by method for manufacturing a laminated product according to independent claim 5.

Further advantages, features, aspects and details of the invention are evident from the dependent claims, the description and the drawings.

According to the present invention, there is provided a laminated product including: a wiring layer and an insulating layer being alternately laminated, i.e. laminated one on the other, and different wiring layers being electrically connected to each other by a via hole passing through the insulating layer, wherein at least one of the insulating layers is a laminated body including: an insulating resin layer on a lower wiring layer and a glass-cloth containing resin layer thereon, and in the laminated body, the via hole continuously passes through from the glass-cloth containing resin layer to the insulating resin layer.

Preferably, the laminated product is provided in a structure including a glass-cloth containing resin layer. Preferably, the at least one insulating layer is formed of the laminated body. Preferably, the via hole passes through from the upper glass-cloth containing layer to the lower insulating resin layer.

Further, there is provided, according to the invention, a laminated product comprising wiring layers and one or more insulating layers, the wiring layers and the one or more insulating layers being laminated one on the other, wherein different ones of the wiring layers are electrically connected to each other by a via hole passing through the one or more insulating layers, and wherein at least one of the one or more insulating layers is a laminated body including: an insulating resin layer on a lower wiring layer and a glass-cloth containing resin layer thereon, and wherein in the laminated body, the via hole continuously passes through from the glass-cloth containing resin layer to the insulating resin layer.

Further, a laminated product including a glass-cloth containing resin layer according to the present invention is manufactured by a method including the steps of: laminating at least one, preferably more than one, set of a wiring layer and an insulating layer, one on the other, on a lower board with a wiring layer, and electrically connecting different ones of the wiring layers to each other by a via hole passing through the insulating layer or layers, making at least one of the insulating layer or layers be a laminated body including: an insulating resin layer and a glass-cloth containing resin layer successively formed on a lower wiring layer, and laser processing the laminated body so that a hole for making the via hole is continuously made from the glass-cloth containing resin layer to the insulating resin layer.

In accordance with this invention, there is provided a via hole made using a continuous through-hole made by collectively laser-processing a glass-cloth containing resin layer and an insulating resin layer therebelow which constitute a composite insulating layer lying between an upper and a lower wiring layer. In the case of a conventional method for making the via hole which requires that different resin layers are formed and laser processing is done for the resin layers, respectively, high laser processing accuracy is required as compared with the collective laser processing for two layers. On the other hand, the laminated product according to this invention capable of collectively laser-processing the glass-cloth containing resin layer and the insulating resin layer therebelow can be given as a multiple-layer product by a simple step and at low cost. Further, in accordance with this invention, conduction processing for the thorough-hole can be done more simply as compared with the conduction processing for the hole with a small diameter which is finally made by executing the laser processing twice according to the conventional art.

Thus, a laminated product including a glass-cloth containing resin layer having a multiple-layer structure capable of making a via hole by a simple step, and a method for manufacturing the same can be achieved.

The invention is also directed to apparatuses for carrying out the disclosed methods and including apparatus parts for performing each described method steps. These method steps may be performed by way of hardware components, a computer programmed by appropriate software, by any combination of the two or in any other manner.

The invention will be better understood by reference to the following description of embodiments of the invention taken in conjunction with the accompanying drawings, wherein:
Fig. 1 is a schematic view for explaining the laminated product in a structure including a glass-cloth containing resin layer according to this invention.
Figs. 2A to 2D are views for explaining manufacture of a multiple-layer product according to this invention.
Figs. 3A to 3E are views for explaining formation of a via hole in the laminated product in a structure including a glass-cloth containing resin layer according to a conventional art.

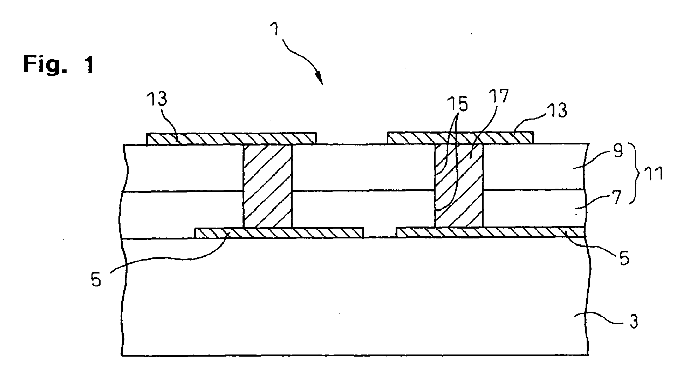

Fig. 1 schematically shows a laminated product 1 in a structure including a glass-cloth containing resin layer, i. e. a resin layer containing a glass-cloth, according to this invention. The laminated product 1 as shown in Fig. 1 includes an insulating resin layer 7 overlying a lower wiring board 3 equipped with a lower wiring layer 5, and a glass-cloth containing resin layer 9, the insulating resin layer 7 and the glass-cloth containing resin layer 9 constituting a single insulating layer 11. On the insulating layer 11, an upper wiring layer 13 is located. The lower wiring layer 5 and the upper wiring layer 13 are electrically connected by a via hole 17 of a conductive material filled into a hole 15 which successively passes through the glass-cloth containing resin layer 9 and insulating resin layer 7. In this invention, the "hole continuously passing through" means that the hole for the via hole passing from upper glass-cloth containing resin to the lower insulating resin layer extends from the glass-cloth containing resin layer to the insulating resin layer without substantially discontinuously changing the diameter at the interface or its vicinity between the glass-cloth containing resin layer and the insulating resin layer, i.e. without forming a level difference due to a change in the diameter at the interface and its vicinity between both layers. On the upper wire layer 13, another set of the insulating layer and wiring layer may exist.

The lower wiring board 3 equipped with the lower wiring layer 5 may be a core board which is used to manufacture a multiple-layer board having a build-up layer formed thereon. Otherwise, it may be such a core board having at least one set of an insulating layer and a wiring layer built-up thereon.

The insulating resin layer 7 which constitutes the insulating layer 11 can be made of an insulating resin which is generally used to form an interlayer insulating layer in the multiple-layer wiring board. This insulating resin may contain e.g. a filler of glass particles. The glass-cloth containing resin layer 9 located on the insulating resin layer 7 is made by impregnating the glass-cloth with the insulating resin, and is made of the material called "prepreg". Both materials can be selected from the materials which are generally used in manufacture of the multiple-layer wiring board.

The glass-cloth containing resin material used to form the glass-cloth containing resin layer 9 is commercially available as a product having a predetermined thickness. The product having a sufficient thickness to obtain a necessary reinforcement effect can be selectively adapted. For example, the material having the thickness of about 40 µm or 60 µm can be employed. The insulating resin layer 7 underlying the glass-cloth resin layer 9 is formed with such a thickness that the laminated body of itself and the glass-cloth containing resin layer 9 has the thickness necessary to assure the insulation between the upper and lower wiring layers. The thickness is generally about 40 to 100 µm.

The via hole 17 which continuously passes through the upper glass-cloth containing resin layer 9 and the lower insulating resin layer 7 can be formed by a CO₂ laser device as in a common via hole material. The diameter of the via hole 17 is not particularly limited, but generally 100 to 300 µm, preferably about 150 to 200 µm.

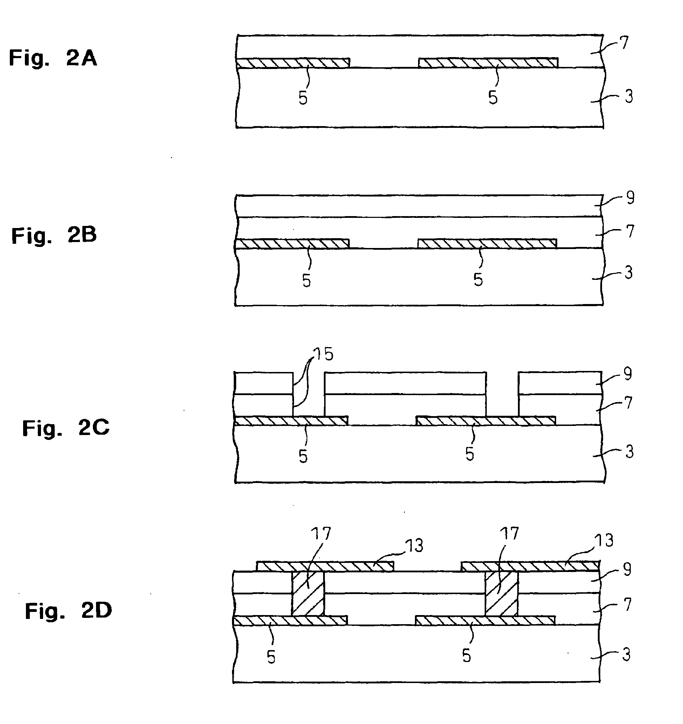

Now referring to Figs. 2A to 2D, an explanation will be given of manufacture of the laminated product in a structure including a glass-cloth containing resin layer according to this invention.

As shown in Fig. 2A, the insulating resin layer 7 (thickness of 40 µm) covering the lower wiring layer 5 overlying the lower wiring board 3 is formed. This insulating resin layer 7 can be formed of epoxy resin containing e.g. a glass particle filler by about 20 wt %. A glass-cloth containing resin sheet is placed on the insulating resin layer 7 and stamped to form the glass-cloth containing resin layer 9 as shown in Fig. 2B. The glass-cloth containing resin sheet may be GHPL-830HS (thickness of 40 µm) which is commercially available from e.g. Mitsubishi Gas Chemical Company, Inc.

Subsequently, using the laser device LC-2G manufactured by e.g. Hitachi Via Mechanics, Ltd, the glass-cloth containing resin layer 9 and the insulating resin layer 7 underlying it are successively processed to make a hole 15 having a diameter of 150 µm which passes through the glass-cloth containing resin layer 9 and the insulating resin layer 7 so as to expose a part of the lower wiring layer 5, as shown in Fig. 2C. During the laser processing, the lower wiring layer 5 (or possibly a pad communicating with the lower wiring layer 5) made of the metallic material of e.g. Cu exposed to the bottom of the hole 15 by the processing serves as a stopper so that the processing can be completed when the depth of the hole 15 reaches the lower wiring layer 5. As regards laser processing capability, the glass-cloth containing resin layer 9 is inferior to the insulating resin layer 7 having the filler of glass particles. The laser processing capability can be defined by the speed of formation of a via hole by a laser, i.e. a superior or inferior laser processing capability implies a fast or slow formation of a via hole by a laser, respectively.

Generally, where the processing of hole making is successively executed for different materials, if the processing is executed precedently for the material having good laser processing capability and subsequently for the material poor laser processing capability, at the stage when the processing is shifted from the former to the latter, an inconvenience such as reduction of a processing diameter occurs. On the other hand, if the processing is executed precedently for the glass-cloth containing resin layer 9 having poor laser processing capability and subsequently for the insulating resin layer 7 having good laser processing capability, without being plagued with the inconvenience such as reduction in the processing diameter, a hole having substantially the same diameter as that made in the glass-cloth containing resin layer 9 can be made in the lower insulating resin layer 7. In addition, the collective processing of hole making for the upper glass-cloth containing resin layer 9 and lower insulating resin layer 7 will not face the inevitable problem of strict laser processing accuracy in the method disclosed in Patent Reference 1 in which after the hole having a large diameter has been made, another hole having a diameter smaller than the large diameter is made within the hole having the large diameter.

Next, as shown in Fig. 2D, the hole 15 is filled with Cu plating by the ordinary technique to form a via hole 17. Thereafter, the upper wiring layer 13 can also be formed by a known technique. On the upper wire layer 13, another set (not shown) of the insulating layer and wiring layer can be formed.

Hitherto, the laminated product according to this invention has been explained with reference to the multiple-layer board. However, without being limited to it, the laminated product according to this invention can also be applied to various products in a multiple-layer structure including the glass-cloth containing resin layer as a reinforcement layer, e.g. a package product. Therefore, it should be understood that the laminated product according to this invention includes these various products.

## Claims

1. A laminated product comprising:
a wiring layer (5, 13) and an insulating layer (11) being laminated one on the other, and
different wiring layers (5, 13) being electrically connected to each other by a via hole (17) passing through the insulating layer (11), wherein
at least one of the insulating layers (11) is a laminated body including: an insulating resin layer (7) on a lower wiring layer (5) and a glass-cloth containing resin layer (9) thereon, and
in the laminated body, the via hole (17) continuously passes through from the glass-cloth containing resin layer (9) to the insulating resin layer (7).

2. The laminated product according to claim 1, wherein
the glass-cloth containing resin layer (9) is inferior to the insulating resin layer (7) as regards laser processing capability.

3. The laminated product according to any of the claims 1 or 2, wherein
the diameter of the via hole (17) is 100 to 300 µm.

4. The laminated product according to any of the claims 1 to 3, wherein
the diameter of the via hole (17) is about 150 to 200 µm.

5. A method for manufacturing a laminated product including a glass-cloth containing resin layer (9) comprising the steps of:
laminating at least one set of a wiring layer (5, 13) and an insulating layer (11), one on the other, on a lower board with a wiring layer (5), and
electrically connecting different wiring layers (5, 13) to each other by a via hole (15) passing through the insulating layer (11),
making at least one of insulating layers (11) be a laminated body including: an insulating resin layer (7) and a glass-cloth containing resin layer (9) successively formed on a lower wiring layer (5), and
laser processing the laminated body so that a hole (15) for making the via hole (17) is continuously made from the glass-cloth containing resin layer (9) to the insulating resin layer (7).

6. The method according to claim 5, wherein
the diameter of the via hole (17) is 100 to 300 µm.

7. The method according to claim 5 or 6, wherein
the diameter of the via hole (17) is about 150 to 200 µm.

8. The method according to any of claims 5 to 7, wherein
the glass-cloth containing resin layer (9) is inferior to the insulating resin layer (7) as regards laser processing capability.
